# EUROPEAN PATENT APPLICATION

(11) **EP 2 445 321 A1**
(43) Date of publication of application: **25.04.2012**
(21) Application number: 10187367.7
(22) Date of filing: 13.10.2010
(51) Int. Cl.: H05K 3/00, H05K 3/02, H05K 3/10, H01L 21/768, G06F 3/033

(54) **Conductive circuits for a touch panel and the manufacturing method thereof**

(71) Applicant: Innovation & Infinity Global Corp., Hsinchu City (TW)
(72) Inventor: Chu, Chao-Chieh, 300, Hsinchu City (TW)
(74) Representative: Viering, Jentschura & Partner

(57) **Abstract**

A manufacturing method of conductive circuits of a touch panel includes the following steps: providing a substrate (10) with a conductive area thereon; providing at least one hard coating layer (11) on the conductive area of the substrate; forming a plurality of grooves (111) on the hard coating layer; forming a metal layer (12) on the hard coating layer and in the grooves; and heating the metal layer so as to condense the metallic materials thereof in the grooves due to surface tension, thus forming a plurality of conductive circuits (13).

## Description

### BACKGROUND OF THE INVENTION

### Field of the Invention

The instant disclosure relates to a conductive circuit of a touch panel and the manufacturing method thereof, and more particularly, to a conductive circuit in a touch panel that requires no etching process and the manufacturing method thereof.

### Description of the Related Art

Technology advancement has raised the standard of user interface with today's consumer electronics. Improvements in areas such as visual display, flexible operations, and fast response time are greatly desired. In particular, touch-based interactive technology has been widely used in replacing external keyboards, such as in PDAs (personal digital assistant) and cell phones.

Current touch panel technologies include resistive, capacitive, infrared, and surface acoustic wave type. The resistive and capacitive type touch panels are most commonly seen. The capacitive based touch panels can be divided into two groups, namely surface capacitance and projected capacitance. The surface capacitive touch panel detects the presence and location of a single touch in the display area, while the projected capacitive touch panel offers multi-touch ability to simultaneously register multiple distinct positions of input touches. Such flexibility allows capacitive based touch panels to be very popular among advanced consumer electronics.

Structurally, a capacitive touch panel comprises a substrate, with an indium tin oxide (ITO) coated sensing area and a conductive area disposed on the substrate. By photolithography and etching, a plurality of conductive wires are formed on the conductive area and electrically connected to the ITO coated sensing area.

To expand the multi-touch capability, the number of conductive wires must increase significantly. However, to ensure the sensing area is maximized, the width of the conductive wire must be narrowed to dispose enough conductive wires on the defined substrate. According to the Taiwan Patent Publication # 201001004 and Patent # M348999, conductive wires fabricated by photolithography and etching are disclosed. However, such procedures are difficult in narrowing the width of the conductive wire. In addition, the width of a conductive wire may be inconsistent section by section, which results poor impedance stability or increases the overall impedance of the conductive wire. In turn, the signal response time is delayed accordingly. Also, according to the Taiwan Patent # M354807, a photoresist (PR) stripping technology is disclosed. However, the fabrication process is relatively complicated associated with high production cost.

Based on research and related industrial experience, the inventor proposes the following solution for addressing the above issues.

### SUMMARY OF THE INVENTION

The object of the instant disclosure is to provide a manufacturing method of conductive circuits for a touch panel. Such method replaces the conventional micro-fabrication processes such as photolithography and etching. In turn, conductive circuits with good impedance stability and low impedance can be manufactured. Also, the instant disclosure provides a more simplified manufacturing approach in comparing to conventional processes.

The manufacturing method of conductive circuits for a touch panel comprises the steps of:
Step 1: preparing a substrate having a conductive area;
Step 2: preparing at least one hard coating layer on the conductive area of the substrate;
Step 3: forming a plurality of grooves on the hard coating layer;
Step 4: forming a metal layer on the surface of the hard coating layer and within the grooves; and
Step 5: applying heat to the metal layer, where the metallic material condenses in the grooves due to surface tension in forming a plurality of conductive circuits.

The instant disclosure further provides a touch panel based on the above described manufacturing method of conductive circuits for a touch panel. The said touch panel comprises a substrate having a conductive area; at least one hard coating layer disposed on the conductive area of the substrate; and a plurality of grooves formed on the hard coating layer, where conductive circuit is formed in the groove due to the effect of surface tension.

The instant disclosure has the following advantage. The groove structure for the conductive circuits on the surface of the hard coating layer is formed by a mechanical process without the need for etching. Then, heat is applied to modify the surface tension of the metal material in the grooves, thereby forming the low impedance conductive circuits in the groove structures for signal transmission. In other words, the instant disclosure provides a simplified manufacturing method that eliminates the need for photolithography and etching procedures. Thus, the manufacturing cost is lowered accordingly.

In order to further appreciate the characteristics and technical contents of the instant disclosure, references are hereunder made to the detailed descriptions and appended drawings in connection with the instant disclosure. However, the appended drawings are merely shown for exemplary purposes, rather than being used to restrict the scope of the instant disclosure.

### BRIEF DESCRIPTION OF THE DRAWINGS

Figs. 1A to 1E illustrate the manufacturing steps of conductive circuits for a touch panel of the instant disclosure.

Fig. 2 shows an internal view of a touch panel of the instant disclosure.

Fig. 3 shows an internal side view of a touch panel of the instant disclosure.

### DETAILED DECRIPTION OF PREFERRED EMBODIMENTS

The instant disclosure provides a manufacturing method of conductive circuits of a touch panel. Such method does not require conventional procedures such as photolithography and etching. Instead, grooves are machined for manufacturing conductive circuits. The instant disclosure offers a simplified manufacturing approach and saves manufacturing cost.

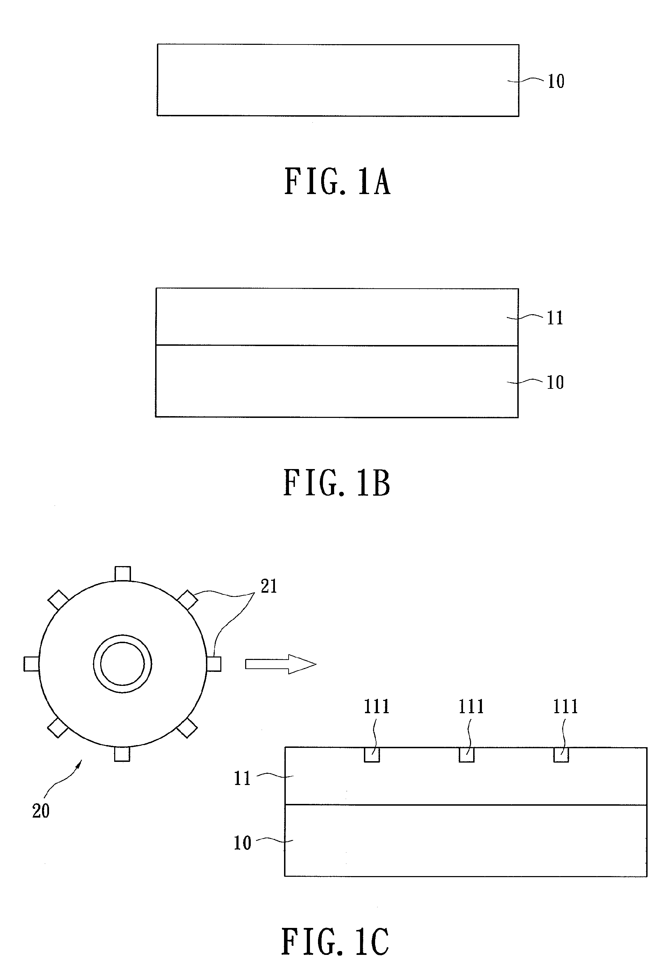

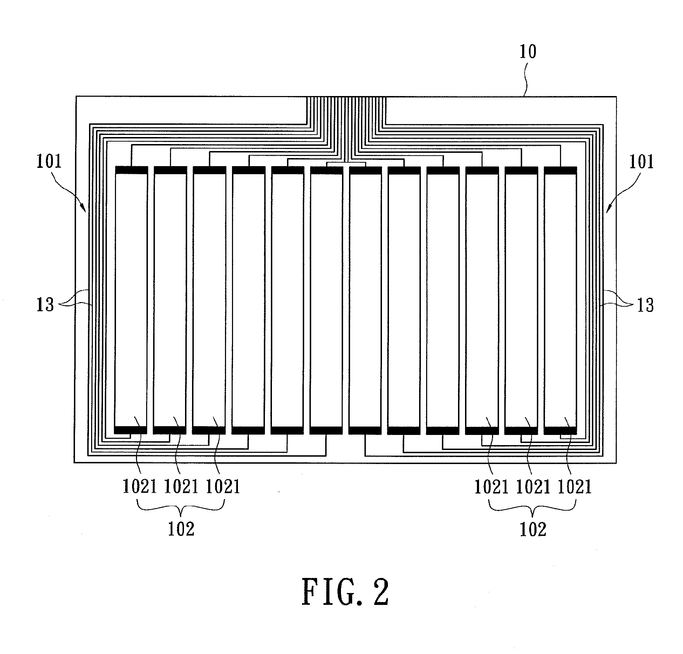

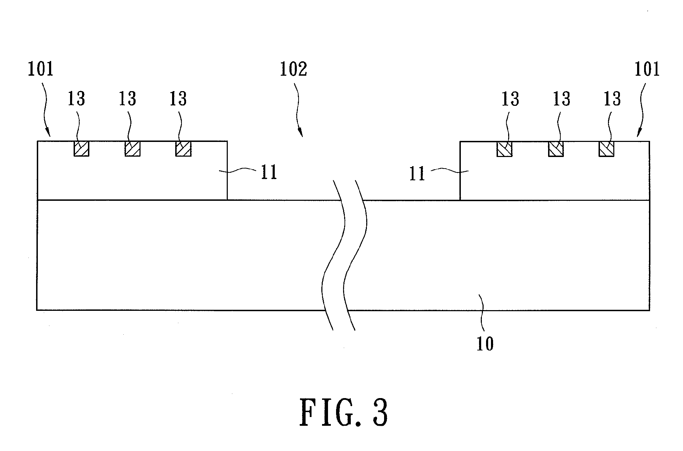

For the instant embodiment, the manufacturing method of conductive circuits of a touch panel comprises the following steps. First, a substrate 10 is prepared as the base of the touch panel shown in Fig. 1A. As shown in Fig. 2 and 3, when the manufacturing process is completed, the substrate 10 includes at least a conductive area 101 and a sensing area 102. The conductive area 101 generally surrounds the border of the sensing area 102. Also, conductive circuits 13 on the conductive area 101 are electrically connected to the sensing area 102 for transmitting input signals. With emphasis on the manufacturing method of conductive circuits 13, Figs 1A thru 1E are used for illustrating the conductive area 101 of the substrate 10 only.

For the instant embodiment, the substrate 10 can be made of any polyester materials such as PET (Polyethylene Terephthalate). Structurally, the substrate 10 can be divided into the conductive area 101 and the sensing area 102. As indicated in Fig. 2, the sensing area 102 has a plurality of sensing elements 1021. Each sensing element 1021 includes at least one transparent metallic conductive coating such as ITO for detecting the input touches from the user.

As shown in Fig. 1B, step 2 involves forming a hard coating layer 11 on the conductive area 101 of the substrate 10. Alternatively, the hard coating layer 11 can be formed over both the conductive area 101 and the sensing area 102 of the substrate 10. The hard coating layer 11 can be made of diamond-like carbon (DLC), silicon-based compound, or metallic oxide materials. In a preferred embodiment, the hard coating layer 11 is made from silicon dioxide, which has a lower value of refractive index at 1.46 and excellent hardness. The hardened silicon dioxide layer enhances the structural stability and strength of the substrate 10. To deposit the hard coating layer 1 l, dip coating or physical/chemical vapor deposition processes such as plasma-enhanced chemical vapor deposition (PECVD) can be performed.

Next, step 3 is to form a plurality of grooves 111 on the hard coating layer 11 as shown in Fig. 1C. For the instant disclosure, the hard coating layer 11 is machined in forming the said grooves 111. For example, a roller 20 with protrusions 21 is rolled on the hard coating layer 11, where the protrusions 21 form the corresponding grooves 111. The width of each groove is approximately 10 nm.

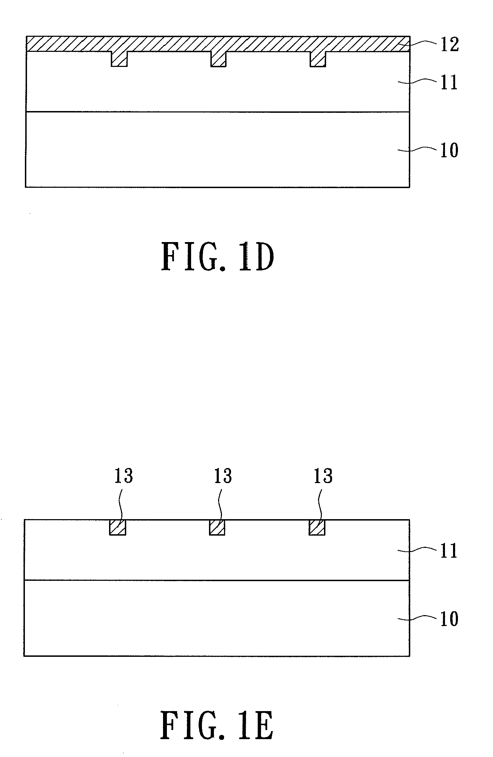

As shown in Fig. 1D, step 4 involves forming a metal layer 12 on the hard coating layer 11 and in the grooves 111. For the instant embodiment, sputter deposition is used to dispose gold alloy and silver materials on the surface of the hard coating layer 11 and in the grooves 111.

Lastly, step 5 involves heating the metal layer 12 to condense the metallic materials into the grooves 111 for forming a plurality of conductive circuits 13. The step is illustrated in Fig. 1E. When heated, the metal layer 12, which is very thin, melts and condenses into the channeled surfaces formed by the grooves 111 due to surface tension. The condensed metallic materials in the grooves 111 form the conductive circuits 13. In the instant embodiment, the heating temperature can be raised to or above 150 C, which allows the metallic materials to flow and condense in the patterned grooves 111 in forming the conductive circuits 13. The formed conductive circuits 13 are located in the conductive area 101 and electrically connected to the sensing area 102 as shown in Fig. 2. The conductive circuits 13 transmit the detected input signals from the sensing area 102 to various electrical elements.

In summary, the instant embodiment uses a roller 20 to machine the hard coating layer 11 in forming the grooves 111 for laying the circuits. Next, a metal layer 12 of excellent conductive properties is laid on the hard coating layer 11. By heating the metal layer 12, the thin metal layer 12 melts and condenses into the grooves 111 due to surface tension. Based on the patterned grooves 111, the condensed metallic materials thus form a plurality of conductive circuits 13. For forming conductive circuits 13 on the substrate 10 to transmit input signals effectively, the instant disclosure does not require using the conventional photolithography and etching procedures.

For the embodiment of the instant disclosure, the impedance of the formed conductive circuits 13 is SΩ, which meets the requirement for transmitting input signals from the sensing area 102 to various electronic elements.

Based on the discussed fabrication method of conductive circuits, a touch panel is fabricated of the instant disclosure. The touch panel comprises a substrate 10 having a conductive area 101; at least one hard coating layer 11 is disposed on the conductive area 101 of the substrate 10; and a plurality of grooves 111 are formed on the hard coating layer 11, where each groove 111 has a conductive circuit 13 formed by the condensed metallic materials due to surface tension.

Please refer to Figs. 2 and 3, which show the touch panel has a sensing area 102 on the substrate 10. In one embodiment, the conductive area 101 is located about the border of the sensing area 102, and the conductive circuits 13 are electrically connected to the sensing elements 1021 of the sensing area 102. The conductive circuits 13 transmit the input signals detected by the sensing elements 1021 to various electronic components.

In particular, each sensing element 1021 has at least one transparent metallic conductive coating (not shown) on the substrate 10. Such transparent metallic conductive coating can be made of ITO material but not limited to. Meanwhile, gold alloy or silver materials can be used to form the conductive circuits 13 with low impedance and excellent signal transmitting ability.

Based on the above discussions, the instant disclosure has the following advantages. Mainly, grooves for the conductive circuits were formed by machining the hard coating layer. Next, the metal layer is heated to form the conductive circuits with the heated metallic materials condensing within the patterned grooves due to surface tension. Thus, the conductive circuits are used to transmit input signals from the user. In other words, the instant disclosure does not require complicated micro-fabrication processes such as photolithography or etching. Hence, the manufacturing method is simplified, and the manufacturing cost is lowered accordingly.

The descriptions illustrated *supra* set forth simply the preferred embodiments of the instant disclosure; however, the characteristics of the instant disclosure are by no means restricted thereto. All changes, alternations, or modifications conveniently considered by those skilled in the art are deemed to be encompassed within the scope of the instant disclosure delineated by the following claims.

## Claims

1. A manufacturing method of conductive circuits of a touch panel, comprising the steps of:
providing a substrate having a conductive area;
providing at least one hard coating layer on the conductive area of the substrate;
forming a plurality of grooves on the hard coating layer by an mechanical procedure;
forming a metal layer on the surface of the hard coating layer; and
applying heat to the metal layer for forming a plurality of conductive circuits.

2. The manufacturing method of conductive circuits of a touch panel of claim 1,
wherein the mechanical procedure comprises using a roller with protrusions for rolling and pressing on the hard coating layer in forming the grooves.

3. The manufacturing method of conductive circuits of a touch panel of claim 2, wherein a sputter deposition process is used to dispose metallic materials on the hard coating layer and in the grooves in forming a metal layer.

4. The manufacturing method of conductive circuits of a touch panel of claim 3, wherein the heating temperature for the metallic materials is raised to 150 C; the metallic materials condense in the grooves and form the patterned conductive circuits accordingly for transmitting input signals.

5. A touch panel, comprising:
a substrate having a conductive area;
at least one hard coating layer disposed on the conductive area of the substrate having a plurality of groove structures formed thereon, the groove structures formed by a roller with protrusions; and
a plurality of conductive circuits in the groove structures formed by condensation of metallic materials via a heating process.

6. The touch panel according to claim 5, wherein the touch panel further comprises a sensing area on the substrate; the sensing area is surrounded by the conductive area and connected to the conductive circuits.

7. The touch panel according to claim 6, wherein the sensing area has at least one sensing element; the sensing element has at least one transparent conductive coating.

8. The touch panel according to claim 7, wherein the transparent conductive coating is made of indium tin oxide (ITO) material.

9. The touch panel according to claim 5, wherein the material of the conductive circuits is selected from the group consisting of gold alloys and silver.
